# EUROPEAN PATENT APPLICATION

(11) **EP 1 351 280 A2**
(43) Date of publication of application: **08.10.2003**
(21) Application number: 03100480.7
(22) Date of filing: 27.02.2003
(51) Int. Cl.: H01L 21/00, H01L 21/306, B08B 3/00

(54) **Method and apparatus for cleaning and drying semiconductor wafers**

(30) Priority: 28.02.2002 KR 2002010969; 01.10.2002 KR 2002059764; 01.10.2002 KR 2002059765
(71) Applicant: A-Tech Limited, Pyungtaek-city, Kyungki-do (KR)
(72) Inventor: Park, Jin-koo, Ansan-city Kyungki-do (KR); Lee, Joong-yeon, Icheon-city Kyungki-do (KR); Yoon, Neung-goo, Pyungtaek-city Kyungki-do (KR); Lee, Chang-keun, Pyungtaek-city Kyungki-do (KR); Lee, Sang-ho, Seoul (KR)
(74) Representative: Stanley, David William

(57) **Abstract**

In an apparatus and method for cleaning and drying a semiconductor wafer (W), isopropyl alcohol and deionised water are premixed in a desired ratio to make a cleaning solution that is supplied into a treating bath (11), in which the wafer (W) is cleaned. Accordingly, chemical compounds remaining due to deionised water can be effectively removed and the creation of water marks due to isopropyl alcohol can be effectively prevented. As a result, cleaning and drying effects can be increased and the cleaning solution can be reused.

## Description

The present invention relates to method and apparatus for cleaning and drying semiconductor wafers.

Most semiconductor wafer cleaning methods were developed in the 1970s, and use large amounts of chemical solutions. A typical cleaning method of removing pollutants remaining on a semiconductor wafer includes a standard clean-1 (SC1) process of removing particles and organic pollutants at an ambient temperature or a high temperature using a mixture of 1:4:20 of ammonia, hydrogen peroxide, and water and a standard clean-2 (SC2) process of removing transient metal pollutants at a high temperature using a mixture of 1:1:5 of hydrochloric acid, hydrogen peroxide, and water.

In another cleaning method, a piranha cleaning process is first performed to remove an organic pollutant such as a sensitizer or a surfactant at a high temperature using a mixture of sulphuric acid and hydrogen peroxide and an HF cleaning process is lastly performed to effectively remove a natural oxide layer from the surface of a wafer, and simultaneously, a metal pollutant from the natural oxide layer.

The above-described conventional cleaning methods have problems in that a large amount of chemical solution is used during the cleaning process, and the chemical solution is mainly a mixture of an acid and a base, a base material of the mixture being a hydrogen peroxide, and thus wastewater cannot be easily treated. The use of a large amount of chemical solution and a large amount of cleaning water results in increased cleaning costs and environmental control.

Since most cleaning processes are performed at a high temperature, the chemical solution used for cleaning decomposes and evapourates, which decreases the lifespan of the cleaning solution and the cleaning effect. In addition, the reuse rate of the cleaning solution is reduced due to the excessive use of deionised water (DIW). Also, since the above-described conventional cleaning process is composed of multiple steps, a huge piece of equipment is necessary for performing the cleaning process.

After such a cleaning process, a process of drying the wafer is performed. Such drying processes include spin-drying, isopropyl alcohol (IPA) vapour drying, IPA layer drying, and so forth. Spin-drying is performed to remove cleaning solution remaining on the wafer, using centrifugal force by spinning the wafer at high speed. IPA vapour drying is performed such that IPA vapours contact the surface of the wafer, and residual liquid such as moisture remaining on the surface of the wafer is substituted for IPA, and then removed. IPA layer drying is performed such that a wafer is dipped into a cleaning solution having a DIW layer and an IPA layer. DIW and IPA sequentially contact the wafer to clean residual liquid with DIW, and the residual liquid is substituted for IPA. IPA layer drying is also called marangoni drying.

However, during spin-drying, dust generated in the spinning apparatus may be adsorbed onto the semiconductor wafer due to charging of the semiconductor wafer. Also, moisture remains in the notch lines for dicing the semiconductor wafer into individual chips, trenches or contact holes, and creates water marks.

During IPA vapour drying, since vapour areas are instable, IPA vapours cannot uniformly contact the semiconductor wafer. Thus, the possibility that water marks will be created is high. Also, since flammable IPA vapours are used, accidental fires may break out.

Marangoni drying can solve some problems occurring during spin-drying or IPA vapour drying. However, marangoni drying is not effective in removing various types of pollutants, such as particles, which may remain on the surface of the wafer.

Preferred embodiments of the present invention aim to provide an apparatus and method for cleaning and drying a semiconductor wafer using a mixture of IPA and DIW as a cleaning solution, by which cleaning and drying effects can be increased due to premixing IPA and DIW in an accurate ratio before supplying them into a treating bath in which a cleaning process is performed, and the cleaning solution used in the cleaning process can be circulate and reused to prevent waste and reduce environmental pollution.

According to one aspect of the present invention, there is provided an apparatus for cleaning and drying a semiconductor wafer, the apparatus comprising:
a treating bath that is arranged to be supplied with a cleaning solution from an external source and in which the semiconductor wafer is cleaned and dried;
a cleaning solution mixing unit in which constituents of a cleaning solution to be supplied into the treating bath are mixed in a predetermined ratio and including isopropyl alcohol tanks that are supplied with isopropyl alcohol from an external source, mixing tanks that are supplied with deionised water from an external source and with isopropyl alcohol contained in the isopropyl alcohol tanks for the isopropyl alcohol and deionised water to be mixed together, and level sensing means that sense the amount of isopropyl alcohol supplied into the isopropyl alcohol tanks and the amount of deionised water supplied into the mixing tanks;
a cleaning solution supply unit that connects the mixing tanks to the treating bath and supplies the cleaning solution mixed in the mixing tanks into the treating bath; and
a return line through which cleaning solution used in the treating bath for the cleaning of the semiconductor wafer is returned back to the mixing tanks.

Preferably, at least two isopropyl alcohol tanks of the cleaning solution mixing unit are interconnected in parallel, at least two mixing tanks are connected respectively to the isopropyl alcohol tanks and disposed in parallel so that each of the isopropyl alcohol tanks and each of the mixing tanks make a group, and the cleaning solution circulates through a mixing tank in a group selected from two or more groups.

Preferably, the level sensing means comprises a plurality of level sensors that are installed at the isopropyl alcohol tanks and a plurality of level sensors that are installed at the mixing tanks.

Preferably, the cleaning solution mixing unit further comprises a nitrogen bubble generator that injects nitrogen gas into the mixing tanks so as to completely mix deionised water and isopropyl alcohol.

Preferably, isopropyl alcohol supplementing pumps that supply additional isopropyl alcohol from the isopropyl alcohol tanks into the mixing tanks by a desired amount are further installed between the isopropyl alcohol tanks and the mixing tanks.

Preferably, the cleaning solution supply unit comprises:
a circulating pump that pumps the cleaning solution from the mixing tanks into the treating bath;
a filter that filters impurities from the cleaning solution flowing via the circulating pump;
an isopropyl alcohol concentration measurer that checks the concentration of isopropyl alcohol contained in the cleaning solution that has passed through the filter; and
a liquid particle counter that detects the amount of liquid particles contained in the cleaning solution flowing into the treating bath.

Preferably, the return line comprises a liquid particle counter that detects liquid particles contained in the cleaning solution returning from the treating bath back to the mixing tanks.

Preferably, an apparatus according to any of the preceding aspects of the invention further comprises:
a heating tank that is connected to the cleaning solution mixing unit, that is supplied with cleaning solution from the mixing tanks, and heats the cleaning solution to evaporate isopropyl alcohol from the cleaning solution using the difference between boiling points of isopropyl alcohol and deionised water to decompose the cleaning solution into pure isopropyl alcohol and deionised water;
an isopropyl alcohol filter that is connected to the heating tank and filters impurities from isopropyl alcohol vapour;
an isopropyl alcohol collecting tank that is supplied with isopropyl alcohol filtered through the isopropyl alcohol filter and condenses isopropyl alcohol;
a deionised water filter that is connected to the heating tank and passes deionised water remaining in the heating tank to filter impurities from deionised water; and
a deionised water collecting tank that is supplied with deionised water filtered through the deionised water filter and temporarily stores deionised water.

Preferably, a sink that is supplied with deionised water from an external source and is arranged to submerge a lower portion of the treating bath under deionised water is further installed beneath the treating bath, and the sink is provided with an ultrasonic generator that generates ultrasonic waves, and passes the ultrasonic waves through deionised water and the treating bath to the semiconductor wafer that is being cleaned in the treating bath.

In another aspect, the present invention provides a method of cleaning and drying a semiconductor wafer, the method comprising:
a. mixing deionised water and isopropyl alcohol to make a cleaning solution;
b. supplying the cleaning solution into a treating bath so that the cleaning solution contacts the semiconductor wafer in the treating bath to clean the semiconductor wafer;
c. after the semiconductor wafer is cleaned, separating the semiconductor wafer from the cleaning solution; and
d. drying the semiconductor wafer separated from the cleaning solution to remove cleaning solution remaining on the semiconductor wafer.

In step (b), before the cleaning solution is supplied into the treating bath, the semiconductor wafer may be put into the treating bath.

In step (b), after the supply of the cleaning solution into the treating bath is completed, the semiconductor wafer may be dipped into the cleaning solution.

In step (c), the semiconductor wafer may be lifted up from the treating bath so that the semiconductor wafer is separated from the cleaning solution.

In step (c), the cleaning solution may be discharged from the treating bath so that the semiconductor wafer is separated from the cleaning solution.

In step (a), the concentration of isopropyl alcohol in the cleaning solution may vary according to time to adjust the concentration of isopropyl alcohol to one or more target concentration.

Preferably, in step (d), hot nitrogen gas is sprayed onto the surface of the semiconductor wafer, to dry the surface of the semiconductor wafer.

For a better understanding of the invention, and to show how embodiments of the same may be carried into effect, reference will now be made, by way of example, to the accompanying diagrammatic drawings, in which:
Figure 1 is a schematic view of one example of an apparatus for cleaning and drying a semiconductor wafer according to an embodiment of the present invention;
Figure 2 is a view for explaining a step of dipping a semiconductor wafer into a treating bath during cleaning and drying a semiconductor wafer, according to one embodiment of the present invention;
Figure 3 is a view for explaining a step of dipping a semiconductor wafer into a treating bath during cleaning and drying a semiconductor wafer, according to another embodiment of the present invention
Figures 4A through 4D are views illustrating examples of moving a semiconductor wafer within a cleaning solution to clean further and effectively the semiconductor wafer within a treating bath;
Figure 5 is a view for explaining a method of separating a semiconductor wafer from a cleaning solution after the semiconductor wafer is cleaned in a treating bath using a method of cleaning and drying a semiconductor wafer according to one embodiment of the present invention;
Figure 6 is a view for explaining a step of separating a semiconductor wafer from a cleaning solution after the semiconductor wafer is cleaned in a treating bath in a method of cleaning and drying a semiconductor wafer according to another embodiment of the present invention;
Figure 7 is a view for explaining a step of separating a semiconductor wafer from a cleaning solution after the semiconductor wafer is cleaned in a treating bath in a method of cleaning and drying a semiconductor wafer according to still another embodiment of the present invention;
Figure 8 is a view for explaining a step of spraying nitrogen gas for drying a semiconductor wafer in a method of cleaning and drying a semiconductor wafer according to one embodiment of the present invention;
Figure 9 is a view for explaining a step of spraying nitrogen gas for drying a semiconductor wafer in a method of cleaning and drying a semiconductor wafer according to another embodiment of the present invention;
Figures 10 through 12 are views for explaining a step of changing the position of a semiconductor wafer with respect to an elevating support block when nitrogen gas is sprayed on the semiconductor wafer; and
Figures 13 through 20 are graphs illustrating various ways to adjust the concentration of IPA in a cleaning solution used for cleaning and drying a semiconductor wafer according to an embodiment of the present invention.

In the figures, like references denote like or corresponding parts.

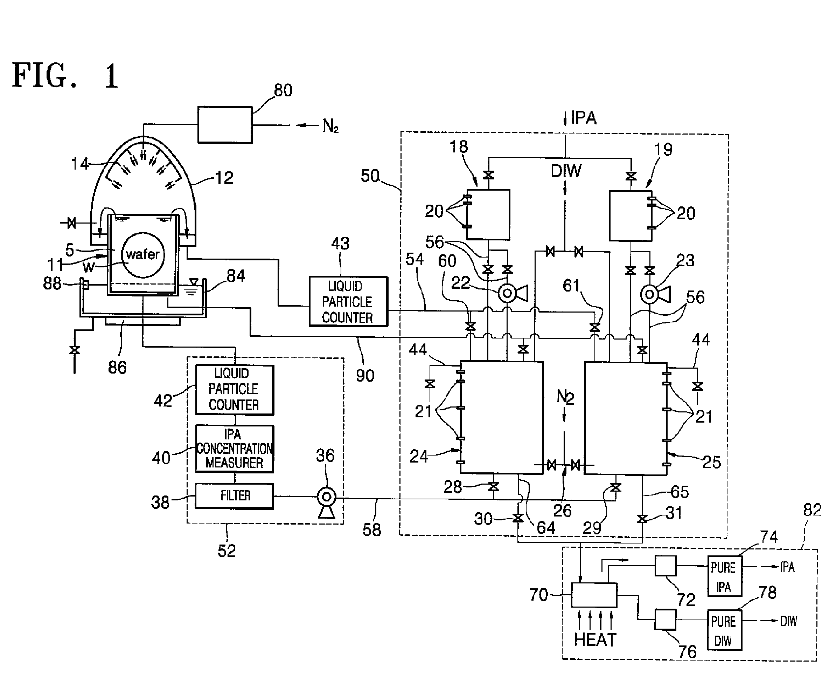

Figure 1 is a schematic view of one example of an apparatus for cleaning and drying a semiconductor wafer according to an embodiment of the present invention. Referring to Figure 1, the apparatus includes a treating bath 11, a cleaning solution mixing unit 50, a cleaning solution supply unit 52, a return line 54, a drain line 90, and a collecting unit 82. A wafer W is cleaned and dried in the treating bath 11. The cleaning solution mixing unit 50 premixes cleaning solutions to be supplied into the treating bath 11 in a predetermined ratio. The cleaning solution supply unit 52 moves the cleaning solution mixed in the cleaning solution mixing unit 50 into the treating bath 11 and checks the state of the cleaning solution. The return line 54 returns the cleaning solution, which overflows after being used in a cleaning process in the treating bath 11, back to the cleaning solution mixing unit 50.

If necessary, the drain line 90 returns the cleaning solution from the treating bath 11 back to the cleaning solution mixing unit 50. The collecting unit 82 is connected to the cleaning solution mixing unit 50 and collects polluted cleaning solution to decompose the polluted cleaning solution into IPA and DIW.

The treating bath 11 may accommodate one or more wafers to be cleaned and dried and is connected to the cleaning solution supply unit 52 and the return line 54. The upper portion of the treating bath 11 is covered with a chamber cover 12 that is already known in the prior art.

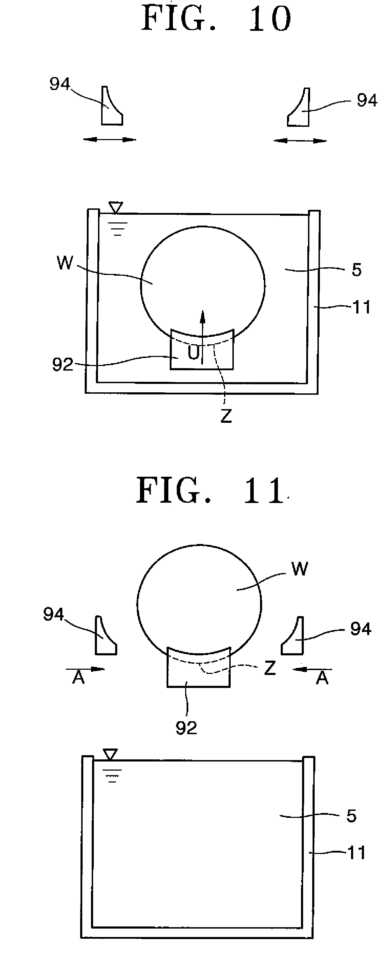

The wafer W is supported by an elevating support block 92 shown in Figure 10 in the treating bath 11. The elevating support block 92 is positioned inside the treating bath 11 when cleaning the wafer W so that the wafer W is sunk under the cleaning solution 5. However, when drying the wafer W, the elevating support block 92 ascends over the treating bath 11 as shown in Figure 11.

The chamber cover 12 covers the treating bath 11 and conveys cleaning solution overflowing from the treating bath 11 to the return line 54. The chamber cover 12 also includes a plurality of nitrogen spraying nozzles 14. The nitrogen spraying nozzles 14 are supplied with nitrogen gas from an external source, and further supply the nitrogen gas into the chamber cover 12 to fill the chamber cover 12 with the nitrogen gas. In particular, the nitrogen nozzles 14 spray the nitrogen gas on the wafer W when the wafer W rises onto the liquid surface of the cleaning solution in order to remove the cleaning solution attached to the surface of the wafer W.

A heater 80 is further installed to heat the nitrogen gas proceeding toward the nitrogen spraying nozzles 14. If necessary, the heater 80 can heat the nitrogen gas to further effectively remove the cleaning solution sticking to the surface of the wafer W.

A sink 84 is installed under the treating bath 11. The sink 84 contains DIW at a predetermined water level so that the lower portion of the treating bath 11 is sunk under the water surface of DIW. A water level sensor 88 is installed inside the sink 84. The level sensor 88 senses the level of DIW so that the lower portion of the treating bath 11 is always positioned under the level of DIW.

An ultrasonic generator 86 is installed beneath the sink 84. The ultrasonic generator 86 may be a standard ultrasonic generator. Ultrasonic waves generated by the ultrasonic generator 86 pass through DIW in the sink 84, and then are transmitted to the wafer W through the treating bath 11 and the cleaning solution 5.

In other words, when DIW is supplied into the sink 84 and the lower portion of the treating bath 11 is dipped into DIW, ultrasonic waves generated by the ultrasonic generator 86 are transmitted to the treating bath 11 through DIW during cleaning of the wafer W.

The cleaning solution mixing unit 50 includes IPA tanks 18 and 19 and mixing tanks 24 and 25 respectively connected to the IPA tanks 18 and 19. Since the IPA tanks 18 and 19 are disposed in parallel, IPA can be supplied simultaneously into the IPA tanks 18 and 19 from an external source. Also, since the mixing tanks 24 and 25 are disposed in parallel, DIW can be supplied simultaneously into the mixing tanks 24 and 25 from an external source.

Each of the IPA tanks 18 and 19 has a plurality of level sensors 20. The level sensors 20 sense the amount of IPA supplied into the IPA tanks 18 and 19 so that the desired amount of IPA is supplied. Each of the mixing tanks 24 and 25 also has a plurality of level sensors 21. The level sensors 21 sense the amount of DIW supplied into the mixing tanks 24 and 25 so that a desired amount of DIW is supplied.

Reference numeral 44 denotes an overflow drainpipe. As will be described later, the overflow drainpipe 44 discharges the cleaning solution outside the mixing tanks 24 and 25 when the cleaning solution returning back via the return line 54 or the drain line 90 rises above a predetermined level in the mixing tanks 24 and 25.

The IPA tanks 18 and 19 are respectively connected to the mixing tanks 24 and 25 via connecting pipes 56. Thus, IPA in the IPA tanks 18 and 19 moves into the mixing tanks 24 and 25 through the connecting pipes 56.

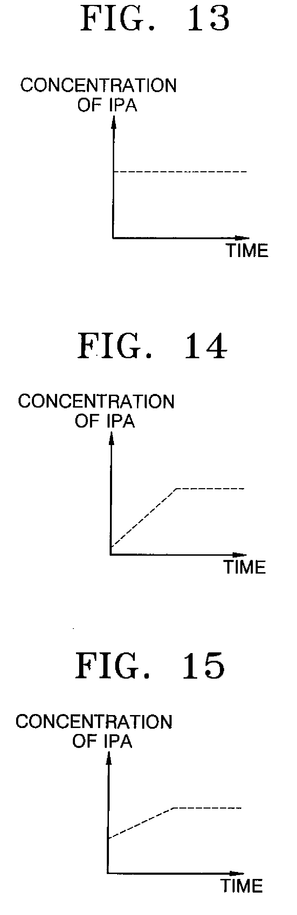

The necessary amount of DIW is separately supplied into the mixing tanks 24 and 25. Thus, in the mixing tanks 24 and 25, IPA supplied from the IPA tanks 18 and 19 is mixed with DIW at a predetermined ratio. Here, the amount of IPA supplied into the IPA tanks 18 and 19 and the amount of DIW supplied into the mixing tanks 24 and 25 can be respectively measured by the level sensors 20 and 21. Thus, the concentration of IPA to DIW can be adjusted, and thus cleaning solutions having a desired concentration can be obtained in the mixing tanks 24 and 25. In other words, the concentration of IPA illustrated in graphs of Figures 13 through 19 (for example) can be obtained.

Each of the connecting pipes 56 is split into two pipes. IPA supplementing pumps 22 and 23 are respectively installed at one of the two split connecting pipes 56. The IPA supplementing pumps 22 and 23 are used to additionally and quickly supply an accurate amount of IPA from the IPA tanks 18 and 19 into the mixing tanks 24 and 25.

Since IPA is volatile, IPA may gradually volatilize during the circulation of the cleaning solution. When IPA volatilizes, the concentration of IPA in the cleaning solution becomes low. Thus, the IPA supplementing pumps 22 and 23 supplement IPA to avoid any shortage of IPA.

As described above, in each of the mixing tanks 24 and 25, IPA and DIW are mixed in a desired ratio. A nitrogen bubble generator 26 is additionally installed in order to completely mix IPA and DIW. The nitrogen bubble generator 26 is supplied with nitrogen gas from an external source, and sprays the nitrogen gas into the lower portions of the mixing tanks 24 and 25 so that DIW and IPA contained in the mixing tanks 24 and 25 are completely mixed.

In the present embodiment, the cleaning solution mixing unit 50 includes the two IPA tanks 18 and 19 and the two mixing tanks 24 and 25. However, the number of IPA tanks and the number of mixing tanks may increase.

The mixing tanks 24 and 25 are connected to a supply pipe 58 via mixed solution supply valves 28 and 29.

The mixed solution supply valves 28 and 29 are opened alternately not simultaneously. In other words, when the mixed solution supply valve 28 is opened, the mixed solution supply valve 29 is closed. Alternatively, when the mixed solution supply valve 28 is closed, the mixed solution supply valve 29 is opened. This means that while the cleaning solution in the mixing tank 24 is circulated and supplied into the treating bath 11, the cleaning solution in the mixing tank 25 is not circulated. In other words, in a case where only the mixed solution supply valve 28 is opened to clean the wafer W using only the cleaning solution contained in the mixing tank 24, and after a predetermined period of time, the cleaning solution is polluted more than a permitted pollution level, the mixed solution supply valve 28 is closed, the mixed solution supply valve 29 is opened, and the cleaning solution contained in the mixing tank 25 is circulated to continue cleaning of the wafer W.

As described above, while the cleaning solution in the mixing tank 25 is supplied into the treating bath 11, a mixed solution discharge valve 30 of the mixing tank 24 is opened to discharge the polluted cleaning solution in the mixing tank 24. When the mixing tank 24 is completely emptied, the mixed solution discharge valve 30 is closed, IPA and DIW are newly supplied from external sources, IPA and DIW are mixed in a desired ratio, and the mixture is maintained in the mixing tank 24.

By alternately using the mixing tanks 24 and 25, a pure cleaning solution can be continuously supplied without stopping the apparatus for cleaning and drying a semiconductor wafer. Thus, a wafer can be quickly and effectively cleaned and dried.

Discharge pipes 64 and 65, which are respectively installed beneath the mixing tanks 24 and 25, discharge the cleaning solution in the mixing tanks 24 and 25 to the collecting unit 82 and are opened and closed by the mixed solution discharge valves 30 and 31.

The collecting unit 82 basically collects the cleaning solution that is polluted to a permitted pollution level or above due to the cleaning of a wafer and remakes the polluted cleaning solution into pure IPA and DIW.

The collecting unit 82 includes a heating tank 70, which is connected to the discharge pipes 64 and 65 and receives the polluted cleaning solution, an IPA collecting tank 74 and a DIW collecting tank 78, which are connected to the heating tank 70, an IPA filter 72, which removes impurities contained in IPA flowing from the heating tank 70 to the IPA collecting tank 74, and a DIW filter 76, which removes impurities contained in DIW flowing from the heating tank 70 to the DIW collecting tank 78.

The heating tank 70 receives and heats the cleaning solution and evaporates IPA in the cleaning solution having a relatively low boiling point to decompose the cleaning solution into DIW and IPA. In other words, the heating tank 70 decomposes the cleaning solution into IPA and DIW using the difference between boiling points of IPA and DIW.

IPA turning into a gaseous state in the heating tank 70 is filtered through the IPA filter 72, moves into the IPA collecting tank 74, is cooled, and is condensed into a liquid state in time.

An additional cooler may be installed to condense IPA. IPA collected in the IPA collecting tank 74 is supplied into the IPA tanks 18 and 19 of the cleaning solution mixing unit 50 and reused.

After IPA flows out of the heating tank 70, polluted DIW remains in the heating tank 70. Polluted DIW is filtered through the DIW filter 76, and then is temporarily stored in the DIW collecting tank 78. DIW collected in the DIW collecting tank 78 is supplied into the mixing tanks 24 and 25 of the cleaning solution mixing unit 50 and reused. Thus, the reuse of the cleaning solution can provide considerable savings of the cleaning solution.

The cleaning solution supply unit 52, which moves the cleaning solution of a predetermined concentration supplied from the cleaning solution mixing unit 50 into the treating bath 11, includes a circulating pump 36, a filter 38, an IPA concentration measurer 40, and a liquid particle counter 42.

The circulating pump 36 is connected to the mixing tanks 24 and 25 via the mixed solution supply valves 28 and 29. The circulating pump 36 pumps the cleaning solutions in the mixing tanks 24 and 25 into the treating bath 11 through the cleaning solution supply unit 52.

The cleaning solution moving into the treating bath 11 via the circulating pump 36 is purified through the filter 38. The filter 38 passes the cleaning solution and filters off impurities contained in the cleaning solution so that the usable period of the cleaning solution is prolonged to its maximum.

The IPA concentration measurer 40 connected to the filter 38 checks the concentration of IPA in the cleaning solution that is circulating. Since IPA is volatile, the concentration of IPA may gradually become low during circulation of the cleaning solution. Due to this, the IPA concentration measurer 40 is installed to continuously check the concentration of IPA in the cleaning solution. When the IPA measurer 40 perceives that the concentration of IPA is reduced, the IPA supplementing pumps 22 and 23 operate to supplement IPA contained in the IPA tanks 18 and 19 into the mixing tanks 24 and 25 so that the cleaning solution returns to an optimum concentration level.

The liquid particle counter 42 detects the amount of liquid particle in the cleaning solution that is circulating to determine whether the cleaning solution has to be replaced. The liquid particle is a pollutant that is not filtered by the filter 38.

The cleaning solution supplied into the treating bath 11 through the cleaning solution supply unit 52 cleans the wafer W in the treating bath 11, overflows from the treating bath 11, and flows to the return line 54.

The cleaning solution flowing through the return line 54 passes through the liquid particle counter 43 again. The liquid particle counter 42 detects liquid particle contained in the cleaning solution, which passed through the treating bath 11, and rechecks the pollution level of the cleaning solution that underwent the cleaning of the wafer W. The cleaning solution passing through the return line 54 returns back into the mixing tanks 24 and 25 via the return valve 60 or 61.

Drying the wafer W is accomplished by lifting the wafer W up over the liquid surface of the cleaning solution. In other words, when the wafer W is lifted up over the liquid surface of the cleaning solution, drying the wafer W is firstly achieved due to the surface tension of the cleaning solution. Next, while the wafer W is rising, the nitrogen gas is sprayed on the wafer W through the nitrogen nozzles 14 to secondly achieve the drying of the wafer W.

The procedure of lifting a wafer up over the liquid surface of a cleaning solution includes: moving the wafer over the liquid surface of the cleaning solution using an elevating support block 92 (shown in Figure 10) while maintaining the level of the cleaning solution; and reducing the level of the cleaning solution without moving the wafer.

The drain line 90 is just an apparatus for reducing the level of the cleaning solution without moving the wafer. The drain line 90 is connected to the lower portion of the treating bath 11 and the mixing tank 24 or 25 and discharges the cleaning solution 5 in the treating bath 11 downward, so that the wafer is firstly dried.

The drain line 90 is provided with return valves to return the cleaning solution back to one of the mixing tanks 24 and 25 being used.

The above-described apparatus for cleaning and drying a semiconductor wafer according to one embodiment of the present invention includes the cleaning solution mixing unit 50, which premixes cleaning solutions in a desired ratio, the cleaning solution supply unit 52, which is supplied with the cleaning solution from the cleaning solution mixing unit 50 and supplies the cleaning solution into the treating bath 11, and the return line 54, which returns the cleaning solution used in the cleaning of the semiconductor wafer in the treating bath 11 back to the cleaning solution mixing unit 50. Thus, since the cleaning solution can be always maintained at an accurate concentration, effects of cleaning and drying the semiconductor wafer are good.

Since the cleaning solution discharged from the cleaning solution mixing unit 50 returns back through the return line 54, and then is reused to perform a cleaning process, the apparatus is economical. In particular, the collecting unit 82 decomposes cleaning solution that is polluted to a permitted pollution level or above into pure IPA and DIW. Thus, the cleaning solution can be reused, the discarded amount of the cleaning solution can be remarkably reduced, and environmental pollution can be reduced.

A method of cleaning and drying a semiconductor wafer using the cleaning and drying apparatus can be basically divided into four steps. The four steps will be described below.

In the first step, DIW and IPA are mixed. As described above, the mixture of DIW and IPA is carried out by the cleaning solution mixing unit 50. In other words, the mixing tanks 24 and 25 are supplied with IPA and DIW, and then IPA and DIW is completely mixed by the nitrogen bubble generator 26.

In the second step, a cleaning solution made by mixing IPA and DIW in the first step is supplied into the treating bath 11 so as to contact the wafer in the treating bath 11.

The cleaning solution may contact a wafer according to two ways. In one of the two ways, a wafer W is put into the treating bath 11 in advance, and then a cleaning solution is supplied into the treating bath 11 to gradually raise the liquid surface of the cleaning solution so that the wafer W is immersed in the cleaning solution. In the other way, when a cleaning solution is continuously supplied into the treating bath 11 to maintain the cleaning solution at a predetermined level, the wafer W descends to be dipped into the cleaning solution.

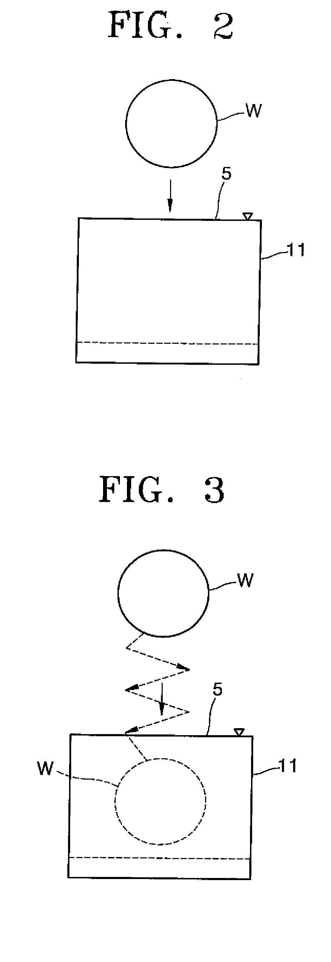

Figures 2 and 3 illustrate a wafer W descending into cleaning solution 5.

Figure 2 illustrates a wafer W that descends vertically, and Figure 3 illustrates a wafer W that descends while swaying from side to side. When the wafer W descends while swaying from side to side, the wafer W agitates the cleaning solution 5, which results in an increase in cleaning effect.

Besides the two methods, the method of dipping a wafer into a cleaning solution may be modified in various ways.

In order to supply cleaning solution into the treating bath 11 with a wafer placed in the treating bath 11 in advance so that the wafer is immersed in the cleaning solution, the treating bath 11 has to be pre-emptied. To empty the treating bath 11, the drain line 90 is opened to return the cleaning solution in the treating bath 11 back to the mixing tanks 24 and 25.

When a wafer is dipped into the cleaning solution, it is preferable that the wafer moves so as to agitate the cleaning solution till the wafer is separated from the cleaning solution.

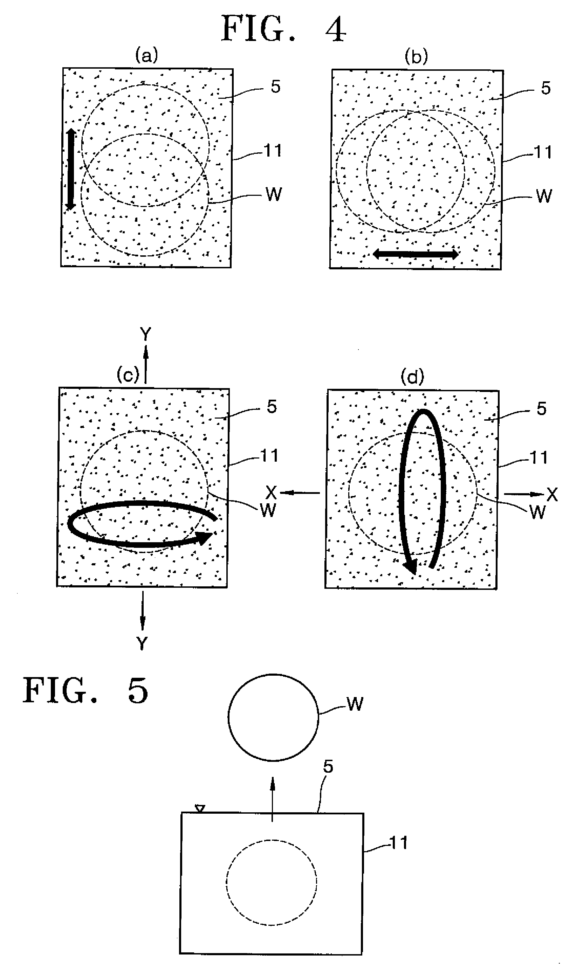

Figures 4A through 4D illustrate a wafer that moves in the cleaning solution.

Figure 4A illustrates a wafer W that sways vertically, Figure 4B illustrates a wafer W that sways horizontally, Figure 4C illustrates a wafer W that turns around a vertical axis (Y-axis), and Figure 4D illustrates a wafer W that turns around a horizontal axis (X-axis).

As described above, impurities such as various types of particles can be effectively removed from the surface of the wafer by moving the wafer within the cleansing solution.

In the third step, the wafer W is separated from the cleaning solution 5. Figures 5 through 7 illustrate a method of separating the wafer W from the cleaning solution 5.

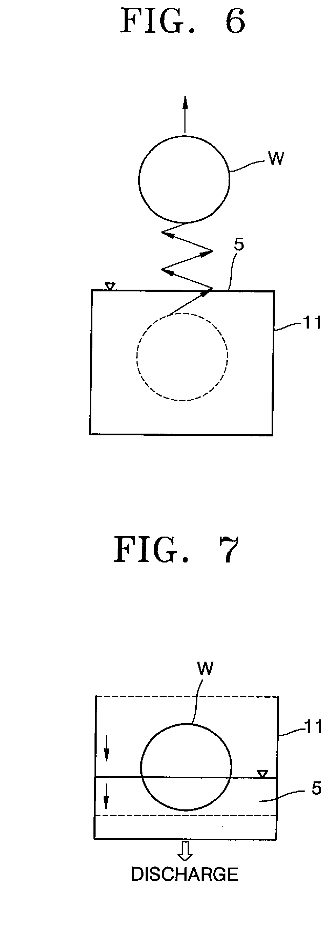

In Figures 5 and 6, the wafer W is lifted up with the liquid surface of the cleaning solution 5 maintained, and in Figure 7, the cleaning solution 5 is discharged with the wafer W left in the treating bath 11. Also, in Figure 5, the wafer W is lifted up vertically, and in Figure 6, the wafer W sways from side to side when being lifted up so that the friction between the wafer W and the cleaning solution 5 increases.

As illustrated in Figures 5 and 6, paths for taking the wafer W out of the treating bath 11 may be changed in other various ways.

The supply of cleaning solution 5 into the treating bath 11 has to stop and the drain line 90 has to be opened in order to discharge the cleaning solution 5 as shown in Figure 7. When the drain line 90 is opened, the cleaning solution 5 in the treating bath 11 returns back to mixing tanks that are operating.

After the wafer W is completely separated from the cleaning solution 5, the fourth step is performed. In the fourth step, the remaining cleaning solution is removed from the surface of the wafer W separated from the cleaning solution 5. Also, the fourth step is carried out in the treating bath 11 from which the cleaning solution 5 is removed or over the treating bath 11 when the cleaning solution 5 remains in the treating bath 11.

In the fourth step, nitrogen gas having a high temperature, preferably a temperature within a range of 50 - 150°C, is blown onto the surface of the wafer W at a predetermined pressure so as to remove the cleaning solution remaining on the surface of the wafer W.

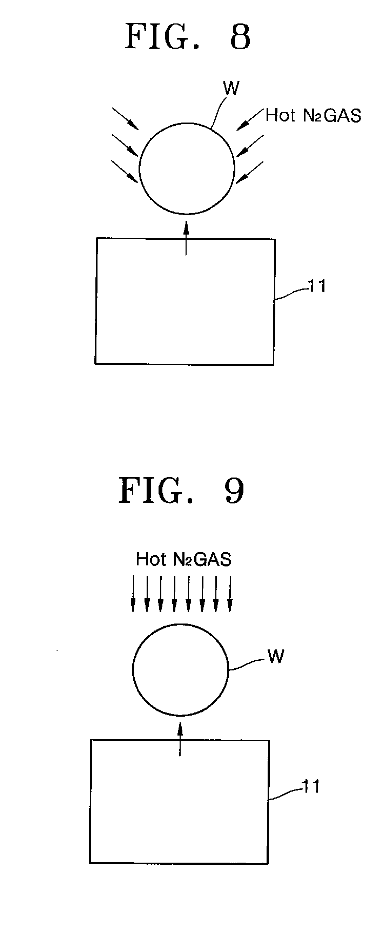

Figure 8 illustrates a state where, when the wafer W is lifted up over the treating bath 11, hot nitrogen gas is blown directionally onto the surface of the wafer W. In this state, the remaining cleaning solution is removed due to the blowing pressure of the nitrogen gas and heat transmitted from the nitrogen gas.

Figure 9 illustrates a state where hot nitrogen gas is sprayed on the wafer W in a vertical laminar flow. Thereafter, the hot nitrogen gas contacts the surface of the wafer W to transmit heat to the surface of the wafer W so that the mixed solution is evaporated and dried.

Figures 10 to 12 are views for explaining a step of changing the position of a wafer relative to an elevating support block and side support blocks when nitrogen gas is sprayed on the wafer. As the elevating support block and the side support blocks, various types of elevating support blocks and side support blocks have been proposed.

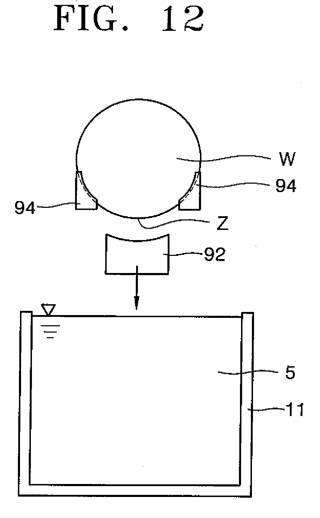

The elevating support block 92 ascends and descends while vertically supporting a plurality of wafers. Side support blocks 94 temporarily separate a wafer W from the elevating support block 92 when the wafer W goes up, so that a lower edge Z of the wafer W is separated from the elevating support block 92 as shown in Figure 12. When the elevating support block 92 ascends, the side support blocks 94 are fully apart from the wafer W so that the wafer W passes through a space between the side support blocks 94.

As can seen in Figure 10, the wafer W is dipped under the cleaning solution 5 when being supported by the elevating support block 92. The side support blocks 94 are positioned over the treating bath 11. The side support blocks 94 are parallel and can move along directions indicated by arrows. If necessary, the side support blocks 94 support sides of the wafer W as shown in Figure 12.

As shown in Figure 10, when the wafer W is completely cleaned under the cleaning solution 5, the elevating support block 92 goes up in direction U indicated by arrow so that the wafer W is separated from the cleaning solution 5. Thereafter, nitrogen gas is sprayed on the wafer W.

Referring to Figure 11, the elevating support 92 completely moves up over the treating bath 11 and the wafer W is positioned between the side support blocks 94. Here, since the lower edge Z of the wafer W contacts the elevating support block 92, the nitrogen gas does not reaches the lower edge Z, and thus the lower edge Z is not completely dried. Thus, the side support blocks 94 move along direction A indicated by arrows so as to support the sides of the wafer W, while the elevating support block 92 temporarily descends as shown in Figure 12.

Referring to Figure 12, the side support blocks 94 support the sides of the wafer W and the elevating support block 92 goes down, so that the nitrogen gas is sprayed on the lower edge Z. Here, the elevating support block 92 must not sink under the cleaning solution 5.

When the wafer W is completely dried, the elevating support 92 ascends and the side support blocks 94 are separated from the wafer W so that the elevating support block 92 re-supports the wafer W, and then the wafer W is taken out from the elevating support block 92.

Finally, the wafer is completely cleaned and dried through the first through fourth steps.

Figures 13 through 20 are graphs illustrating ways to adjust the concentration of IPA with respect to variations in the time required for supplying a cleaning solution into a treating bath. When the concentration of IPA is properly adjusted to working conditions or other requirements, an improved cleaning effect can be achieved. In addition, the adjustment of the concentration of IPA can be realized by the IPA supplementing pumps 22 and 23 described with reference to Figure 1.

Figure 13 illustrates a state where a cleaning solution containing IPA and DIW of a predetermined ratio is supplied into a treating bath without varying the concentration of IPA.

Figure 14 illustrates a state where when only DIW is first supplied into a treating bath, and then the addition of IPA to DIW is gradually increased until the concentration of IPA reaches a predetermined level, when the supply of IPA stops.

Figure 15 illustrates a state where the concentration of IPA of a cleaning solution supplied into a treating bath is gradually increased until it reaches a predetermined level, when the addition of IPA stops.

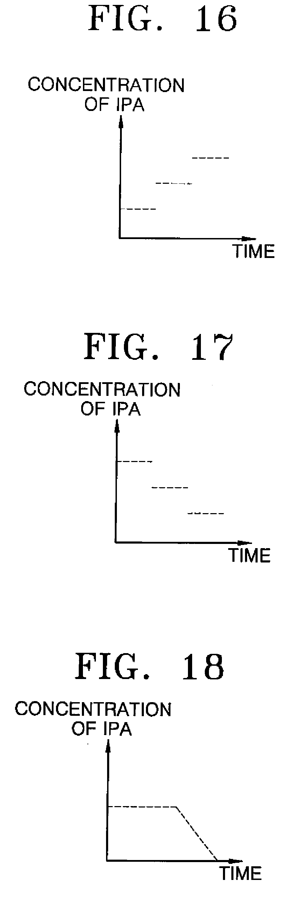

Figure 16 illustrates a state where the concentration of IPA to DIW is increased at regular intervals not gradually.

Figure 17 illustrates a state where only pure IPA is first supplied into a treating bath, and then DIW is supplied into the treating bath at predetermined time intervals, so that the concentration of IPA becomes low.

Figure 18 illustrates a state where a cleaning solution containing IPA of a predetermined concentration is supplied into a treating bath, and then the addition of IPA is reduced from a predetermined point of time, until only DIW is supplied.

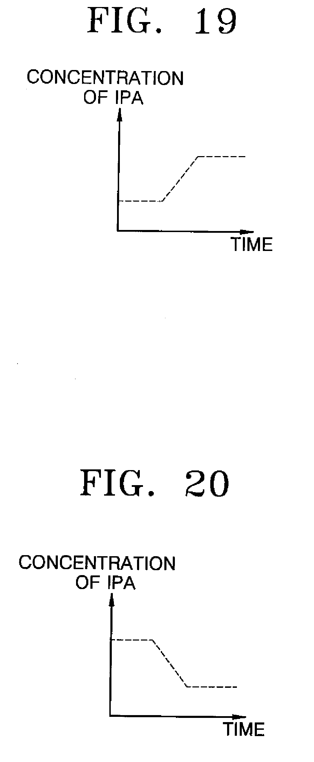

Figure 19 illustrates a state where a cleaning solution containing IPA of a predetermined concentration is first supplied into a treating bath, and then the addition of IPA is gradually increased up to a higher predetermined concentration.

Figure 20 illustrates a state where a cleaning solution containing IPA of a predetermined concentration is first supplied into a treating bath, and then the addition of IPA is gradually reduced to a lower predetermined concentration.

In an apparatus and method for cleaning and drying a semiconductor wafer according to the above-described and illustrated examples of the present invention, before DIW and IPA are supplied into a treating bath, IPA and DIW are completely mixed so that cleaning and drying are both effectively performed. Also, the cleaning solution can be reused to prevent waste of the cleaning solution.

In addition, the semiconductor wafer is taken as an example of an object to be cleaned. However, the object to be cleaned is not limited to the semiconductor wafer, and the present invention may be applied to various objects including a substrate for a liquid crystal display device only, a substrate for a recording disc only, a substrate for a mask only, or the like.

Whilst exemplary embodiments of the present invention have been particularly shown and described, it will be understood by those of ordinary skill in the art that various changes in form and details may be made therein without departing from the spirit and scope of the present invention as defined by the following claims.

In this specification, the verb "comprise" has its normal dictionary meaning, to denote non-exclusive inclusion. That is, use of the word "comprise" (or any of its derivatives) to include one feature or more, does not exclude the possibility of also including further features.

The reader's attention is directed to all and any priority documents identified in connection with this application and to all and any papers and documents which are filed concurrently with or previous to this specification in connection with this application and which are open to public inspection with this specification, and the contents of all such papers and documents are incorporated herein by reference.

All of the features disclosed in this specification (including any accompanying claims, abstract and drawings), and/or all of the steps of any method or process so disclosed, may be combined in any combination, except combinations where at least some of such features and/or steps are mutually exclusive.

Each feature disclosed in this specification (including any accompanying claims, abstract and drawings), may be replaced by alternative features serving the same, equivalent or similar purpose, unless expressly stated otherwise. Thus, unless expressly stated otherwise, each feature disclosed is one example only of a generic series of equivalent or similar features.

The invention is not restricted to the details of the foregoing embodiment(s). The invention extends to any novel one, or any novel combination, of the features disclosed in this specification (including any accompanying claims, abstract and drawings), or to any novel one, or any novel combination, of the steps of any method or process so disclosed.

## Claims

1. An apparatus for cleaning and drying a semiconductor wafer (W), the apparatus comprising:
a treating bath (11) that is arranged to be supplied with a cleaning solution from an external source and in which the semiconductor wafer (W) is cleaned and dried;
a cleaning solution mixing unit (50) in which constituents of a cleaning solution to be supplied into the treating bath (11) are mixed in a predetermined ratio and including isopropyl alcohol tanks (18, 19) that are supplied with isopropyl alcohol from an external source, mixing tanks (24, 25) that are supplied with deionised water from an external source and with isopropyl alcohol contained in the isopropyl alcohol tanks (18, 19) for the isopropyl alcohol and deionised water to be mixed together, and level sensing means (20, 21) that sense the amount of isopropyl alcohol supplied into the isopropyl alcohol tanks (18, 19) and the amount of deionised water supplied into the mixing tanks (24, 25);
a cleaning solution supply unit (52) that connects the mixing tanks (24, 25) to the treating bath (11) and supplies the cleaning solution mixed in the mixing tanks (24, 25) into the treating bath (11); and
a return line (54) through which cleaning solution used in the treating bath (11) for the cleaning of the semiconductor wafer (W) is returned back to the mixing tanks (24, 25).

2. An apparatus according to claim 1, wherein at least two isopropyl alcohol tanks (18,19) of the cleaning solution mixing unit (50) are interconnected in parallel, at least two mixing tanks (24, 25) are connected respectively to the isopropyl alcohol tanks (18,19) and disposed in parallel so that each of the isopropyl alcohol tanks (18,19) and each of the mixing tanks (24, 25) make a group, and the cleaning solution circulates through a mixing tank (24, 25) in a group selected from two or more groups.

3. An apparatus according to claim 1 or 2, wherein the level sensing means (20, 21) comprises a plurality of level sensors (20) that are installed at the isopropyl alcohol tanks (18,19) and a plurality of level sensors (21) that are installed at the mixing tanks (24, 25).

4. An apparatus according to claim 1, 2 or 3, wherein the cleaning solution mixing unit (50) further comprises a nitrogen bubble generator (26) that injects nitrogen gas into the mixing tanks (24, 25) so as to completely mix deionised water and isopropyl alcohol.

5. An apparatus according to any of the preceding claims, wherein isopropyl alcohol supplementing pumps (22, 23) that supply additional isopropyl alcohol from the isopropyl alcohol tanks (18,19) into the mixing tanks (24, 25) by a desired amount are further installed between the isopropyl alcohol tanks (18,19) and the mixing tanks (24, 25).

6. An apparatus according to any of the preceding claims, wherein the cleaning solution supply unit (52) comprises:
a circulating pump (36) that pumps the cleaning solution from the mixing tanks (24, 25) into the treating bath (11);
a filter (38) that filters impurities from the cleaning solution flowing via the circulating pump (36);
an isopropyl alcohol concentration measurer (40) that checks the concentration of isopropyl alcohol contained in the cleaning solution that has passed through the filter (38); and
a liquid particle counter (42) that detects the amount of liquid particles contained in the cleaning solution flowing into the treating bath (11).

7. An apparatus according to any of the preceding claims, wherein the return line (54) comprises a liquid particle counter (43) that detects liquid particles contained in the cleaning solution returning from the treating bath (11) back to the mixing tanks (24, 25).

8. An apparatus according to any of the preceding claims, further comprising:
a heating tank (70) that is connected to the cleaning solution mixing unit (50), that is supplied with cleaning solution from the mixing tanks (24, 25), and heats the cleaning solution to evaporate isopropyl alcohol from the cleaning solution using the difference between boiling points of isopropyl alcohol and deionised water to decompose the cleaning solution into pure isopropyl alcohol and deionised water;
an isopropyl alcohol filter (72) that is connected to the heating tank (70) and filters impurities from isopropyl alcohol vapour;
an isopropyl alcohol collecting tank (74) that is supplied with isopropyl alcohol filtered through the isopropyl alcohol filter (72) and condenses isopropyl alcohol;
a deionised water filter (76) that is connected to the heating tank (70) and passes deionised water remaining in the heating tank (70) to filter impurities from deionised water; and
a deionised water collecting tank (78) that is supplied with deionised water filtered through the deionised water filter (76) and temporarily stores deionised water.

9. An apparatus according to any of the preceding claims, wherein a sink (84) that is supplied with deionised water from an external source and is arranged to submerge a lower portion of the treating bath (11) under deionised water is further installed beneath the treating bath (11), and the sink (84) is provided with an ultrasonic generator (86) that generates ultrasonic waves, and passes the ultrasonic waves through deionised water and the treating bath (11) to the semiconductor wafer (W) that is being cleaned in the treating bath (11).

10. A method of cleaning and drying a semiconductor wafer (W), the method comprising:
a. mixing deionised water and isopropyl alcohol to make a cleaning solution;
b. supplying the cleaning solution into a treating bath (11) so that the cleaning solution contacts the semiconductor wafer (W) in the treating bath (11) to clean the semiconductor wafer (W);
c. after the semiconductor wafer (W) is cleaned, separating the semiconductor wafer (W) from the cleaning solution; and
d. drying the semiconductor wafer (W) separated from the cleaning solution to remove cleaning solution remaining on the semiconductor wafer (W).

11. A method according to claim 10 wherein, in step (b), before the cleaning solution is supplied into the treating bath (11), the semiconductor wafer (W) is put into the treating bath (11).

12. A method according to claim 10 wherein, in step (b), after the supply of the cleaning solution into the treating bath (11) is completed, the semiconductor wafer (W) is dipped into the cleaning solution.

13. A method according to claim 10, 11 or 12 wherein, in step (c), the semiconductor wafer (W) is lifted up from the treating bath (11) so that the semiconductor wafer (W) is separated from the cleaning solution.

14. A method according to claim 10, 11 or 12 wherein, in step (c), the cleaning solution is discharged from the treating bath (11) so that the semiconductor wafer (W) is separated from the cleaning solution.

15. A method according to any of claims 10 to 14 wherein, in step (a), the concentration of isopropyl alcohol in the cleaning solution varies according to time to adjust the concentration of isopropyl alcohol to one or more target concentration.

16. A method according to any of claims 10 to 15 wherein, in step (d), hot nitrogen gas is sprayed onto the surface of the semiconductor wafer (W), to dry the surface of the semiconductor wafer (W).
